# EUROPEAN PATENT APPLICATION

(11) **EP 1 355 414 A1**
(43) Date of publication of application: **22.10.2003**
(21) Application number: 02368041.6
(22) Date of filing: 16.04.2002
(51) Int. Cl.: H03F 1/30, H04M 1/60

(54) **Ripple rejection for amplifier**

(71) Applicant: Dialog Semiconductor GmbH, 73230 Kirchheim/Teck-Nabern (DE)
(72) Inventor: Sexauer, Edgar, 70599 Stuttgart (DE); Graef, Klaus, 73230 Kircheim (DE)
(74) Representative: Schuffenecker, Thierry

(57) **Abstract**

A circuit, where distortions, caused by PSRR in a mobile phone, are significantly reduced, is achieved. The power supply voltage for a signal processing module in a mobile phone is specially filtered by Low Drop Out (LDO) linear voltage regulators or other means of filtering. By filtering the noise in the power supply of a signal processing module the following output stage will not amplify the ripples caused by said noise. In a bridge configuration there is no more the requirement of a perfect symmetrical design and layout of the signal processing module, therefore the costs for manufacturing, design and layout are significantly reduced.

## Description

### Technical field

The invention relates to a mobile telephone circuit, and more particularly, to a specially filtered power supply voltage for the signal processing module feeding the output stage of a mobile phone to reduce distortions by filtering noise on the regulated voltage line.

### Background art

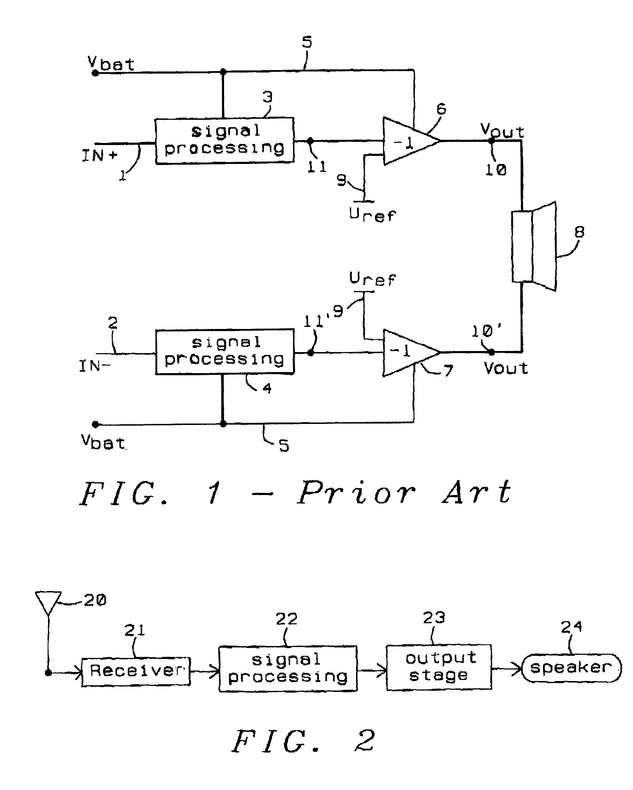

Fig. 1 prior art describes a typical configuration of a signal processing module and a following output stage of a mobile phone. The circuit is done in a symmetrical bridge configuration. The positive **1** and negative **2** audio signals and the power supply voltage **V**_{**bat**} **5** comprise the input to the signal processing modules **3** and **4.** The output of said signal processing module **3** and **4** are the voltages **11** and **11'.** Said output voltages of the signal processing modules are fed into the amplifiers **6** and **7** of the output-stage. Another input of said amplifiers is the reference voltage **V**_{**ref**} **9.** The power supply for said amplifiers is provided by said voltage **V**_{**bat**} **5.** The output of said amplifiers are the **V**_{**out**} voltages **10** and **10'** used as input for the loudspeaker **8.**

A common problem is the coupling of noise from the power supply onto the regulated voltage line. This power supply noise can come from a variety of sources including digital and analog switching or external coupling. A measure of the amount of power supply noise that is coupled onto the regulated power supply is the power supply rejection ratio (PSRR). PSRR is calculated by dividing the ac noise signal present on the regulated dc voltage by the ac noise signal present on the unregulated power supply. It is typically desired that the PSRR be made as high as possible. This supply noise is especially problematic for sensitive analog circuits such as linear signal processing circuits.

In prior art the power supply voltage **V**_{**bat**} **5** is directly linked to the battery. The disadvantage of prior art is that said battery voltage is not regulated and only filtered minimally by external capacitors. The is no monitoring of the battery voltage.

The disadvantage of prior art is that the noise of the power supply voltage **V**_{**bat**} **5** is distorting the audio signals to be amplified by the gain of the output stage. Using a bridge configuration can counterbalance part of the noise signals. Said counterbalancing is only possible if both channels of the bridge configuration have a perfect symmetrical design and layout.

The two parts of the bridge circuit have to be a perfectly mirrored image of each other. The requirement of a perfect symmetrical design in prior art is increasing the complexity and the costs of design and manufacturing.

U.S. Patent 5,541,543 to Arnaud discloses a telephone set fitted with a speech signal loudspeaker also serving as a ringer and more particularly to a device for regulating the power provided to the loudspeaker during a ring signal. U.S. Patent 5,894,212 to Wendt et al. shows a ring signal from a DC power supply using a pair of switches controlled by a pulse width modulation(PWM) circuit.

U:S. Patent 6,252,784 to Dobrenko describes a device for generating an electrical signal suitable for a ringer comprising an amplifier and a power supply generator for supplying a power supply voltage to the amplifier.

U.S. 5,307,407 to Wendt et al. shows a ring signal generator which is producing a ring signal from a DC power supply using a pair of switches controlled by a pulse width modulation (PWM).

### Summary of the invention

A principal object of the present invention is to provide a cost effective onchip solution for mobile phones to reduce distortions caused by noise on the unregulated battery power supply voltage line and enabling a low cost manufacturing method.

A further object of the present invention is to simplify the design and layout of the signal processing module of a mobile phone.

In accordance with the objects of this invention, a circuit with the ability to filter the noise causing distortions in the signal processing module of a mobile phone is achieved. The circuit comprises, first, a loudspeaker, a power supply voltage, means of filtering said power supply voltage and a signal processing module having an input and an output. Said input is an audio signal and said filtered power supply voltage and said output is fed to the output-stage of the mobile phone. Second, said output-stage has an input and an output wherein said input is the output of said signal processing module, a reference voltage and said power supply voltage and said output voltage is driving said loudspeaker.

In accordance with further objects of the invention a circuit in a bridge configuration with the ability to filter the noise causing distortions in the signal processing module of a mobile phone and to simplify design and layout of said signal processing module is achieved. The circuit comprises, first, a loudspeaker, a power supply voltage, means of filtering said power supply voltage and a pair of signal processing modules having an input and an output. Said input is an audio signal and said filtered power supply voltage and said output is fed to a pair of output stages of the mobile phone. Second, said pair of output-stages has each an input and an output wherein said input is the output of said pair of signal processing modules, a reference voltage and said power supply voltage and said output voltage is driving said loudspeaker.

### Description of the drawings

In the accompanying drawings forming a material part of this description, there is shown:
Fig. 1 Prior art illustrates a typical circuit for signal processing modules and related output stages in a bridge configuration.
Fig. 2 illustrates a schematic illustration of a receive path of a wireless phone.
Fig. 3 illustrates a preferred embodiment of the present invention showing an Low Drop Out (LDO) linear voltage regulator to filter the power supply for the signal processing module in a bridge configuration.
Fig.4 is a time chart of the noise in the power supply voltage and in the filtered output voltage of a LDO.
Fig.5 illustrates a preferred embodiment of the present invention showing a LDO to filter the power supply for the signal processing module with one input channel.
Fig. 6 is a time chart of the output voltages of the signal processing module and of the output-stage.

### Description of the preferred embodiments

The preferred embodiments disclose a novel circuit as part of a mobile phone to reduce distortions caused by the power supply rejection ratio of the power supply voltage and simplifying the layout and the manufacturing process. Fig. **2** shows a schematic illustration of a receive path of a mobile phone. In the shown conception of an embodiment the receive path of a mobile phone comprises the antenna **20**, an RF receiver **21**, a signal processing module **22**, an output stage **23** and a speaker **24**. Said novel circuit is comprising the signal processing module **22** and the related power supply.

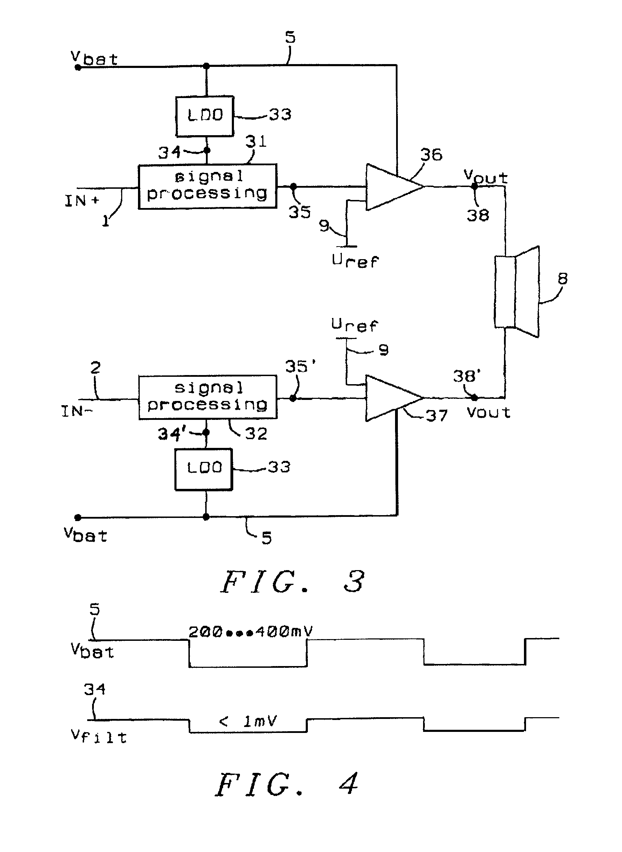

Fig.**3** illustrates a preferred embodiment of the invention. The circuit is done in a symmetrical bridge configuration. The positive **1** and negative **2** audio signals and the power supply voltage **V**_{**bat**} **5** comprise the input to the signal processing modules **31** and **32.** The output of the signal processing modules are the voltages **35** resp. **35'**. Said output voltages of said signal processing modules is fed into the amplifiers **36** resp. **37** of the output stage. Another input of said amplifiers is the reference voltage **V**_{**ref**} **9.** The power supply for said amplifiers is provided by said voltage **V**_{**bat**} **5.** The output of said amplifiers are the voltages **V**_{**out**} **38 resp. V**_{**out**} **38'** used to drive the loudspeaker **8.**

The power supply required by the signal processing modules is provided by the output voltages **V**_{**filt**} **34** resp. **V**_{**filt**} **34'** of the Low Drop Out (LDO) linear voltage regulators **33.** The input of said LDOs **33** is the voltage **V**_{**bat**} **5.**

The audio signals as input to the signal processing module can be any audio signal as voice, music or ringer signals. The same signal processing module, the same output stage and the same loudspeaker can be used for all kinds of said audio signals. Said sharing of circuitry between all kinds of audio signals is reducing the power consumption and the space required on the chip area significantly.

Fig. **4** shows the curves of said power supply voltage **V**_{**bat**} **5** and of said output voltage of the LDOs **V**_{**filt**} **34** or **V**_{**filt**} **34'.** No difference can be shown between both voltages **V**_{**filt**}**.** The same numbers are used for the same voltages as in **Fig. 3.**The size of the noise is reduced by the LDO linear voltage regulators from a value of e.g. 300 mV in the regulated power supply voltage to a value of less than 1 mV. Without the filtering of **V**_{**bat**} **5** by the LDO regulator the noise of the power supply would be amplified together with the audio signal by the gain of the output stage and would lead to substantial distortions at the loudspeaker.

In prior art both channels of the bridge need perfect symmetrical design and layout. Using the voltage **34** resp. **34'** filtered by the LDOs **33** as power supply for the signal processing module the requirement of a perfect symmetry does not exist any more, This provides more flexibility in design and layout and reduces the manufacturing costs.

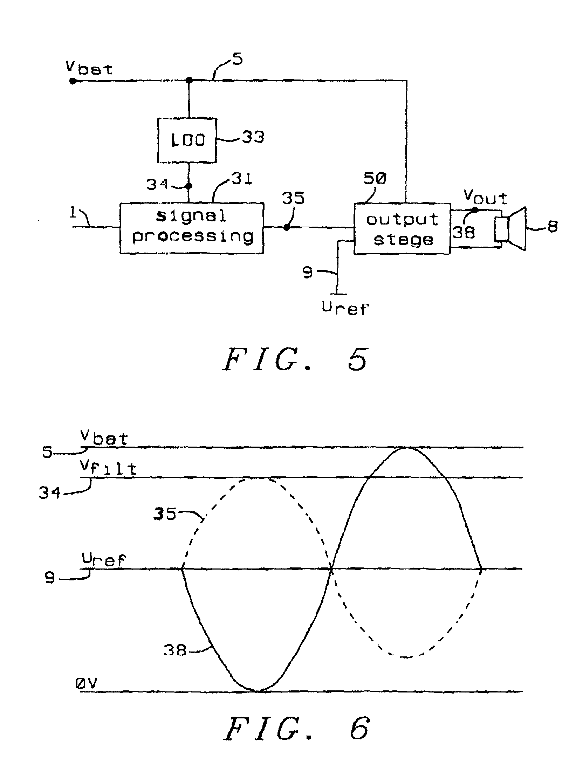

The circuit invented is not limited to a bridge configuration only. **Fig. 5** shows a configuration with one channel only. Same components as shown in previous figures are signified by same numbers. There is one LDO **33**, one signal processing module **31** and one output stage **50** required The benefit of a significantly improved PSRR by using a specially filtered voltage as power supply for the signal processing module is identical to a configuration in a bridge configuration. The components in said configuration are the same as the components in a bridge configuration.

Fig. **6** is a time chart of the output voltage of the output-stage **V**_{**out**} **38** and of the output voltage **35** of the signal processing module, referring to **Fig. 5.** The dotted line shows the output voltage **35** of the signal processing module. The maximal amplitude of said output voltage **35** of the signal processing module **31** equals the output voltage level **V**_{**filt**} **34** of the LDO. Said output voltage level **34** of the LDO is lower than the power supply voltage **V**_{**bat**} **5.** The solid line shows the output voltage **V**_{**out**} **38** at the loudspeaker. With a gain of the output-stage in the magnitude of greater than 1.5 said output voltage **V**_{**out**} **38** can nearly reach the maximal amplitude of the power supply voltage **V**_{**bat**} **5.** The base voltage of both said signals is the reference voltage **V**_{**ref**} **9** of the output-stage.

Compared to the prior art the invention is reducing distortions of the audio signals by reducing PSRR of the power supply of the signal processing module significantly. In a bridge configuration there is no more a need of a perfect symmetrical design and layout using a filtered power supply of the signal processing module. The manufacturing cost and design costs are reduced if the symmetrical design and layout has not to be followed strictly.

## Claims

1. A circuit able to filter the noise causing distortions in the signal processing module of a mobile phone comprising:
- a loudspeaker;
- a power supply voltage;
- means of filtering said power supply voltage;
- a signal processing module having an input and an output wherein said input is an audio signal and said filtered power supply voltage and said output is fed to the output-stage of the mobile phone; and
- an output-stage having an input and an output wherein said input is the output of said signal processing module, a reference voltage and said power supply voltage and said output voltage is driving said loudspeaker

2. A circuit in a bridge configuration able to filter the noise causing distortions in the signal processing module of a mobile phone and to simplify design and layout of said signal processing module comprising :
- a loudspeaker;
- a power supply voltage;
- means of filtering said power supply voltage;
- a pair of signal processing modules having an input and an output wherein said input is an audio signal and said filtered power supply voltage and said output is fed to the amplifier of the output-stage of the mobile phone; and
- a pair of said amplifiers of the output-stage having an input and an output wherein said input is the output of said signal processing modules, a reference voltage and said power supply voltage and said output voltage is driving said loudspeaker.

3. The circuit of claim 1 or claim 2 wherein said means of filtering said power supply voltage for the signal processing module is a Low Drop Out (LDO) linear voltage regulator.

4. The circuit of claim 1 or 2 wherein said input audio signal is a voice signal.

5. The circuit of claim 1 or 2 wherein said input audio signal is a ringer signal.

6. The circuit of claim 1 or 2 wherein said input audio signal is a music signal.

7. The circuit of claim 1 or 2 wherein said input audio signal is a superpositioned signal consisting of voice and ringer signals.

8. The circuit of claim 1 or 2 wherein said input audio signal is a superpositioned signal consisting of voice and music signals.

9. The circuit of claim 1 or 2 wherein said input audio signal is a superpositioned signal consisting of ringer and music signals.

10. The circuit of claim 1 or 2 wherein said input audio signal is a superpositioned signal consisting of voice signals, music signals and ringer signals.
